# EUROPÄISCHE PATENTSCHRIFT

(11) **EP 3 565 394 B1**
(45) Veröffentlichungstag und Bekanntmachung des Hinweises auf die Patenterteilung: **08.09.2021**
(21) Anmeldenummer: 19164258.6
(22) Anmeldetag: 21.03.2019
(51) Int. Cl.: H05K 7/14, H05K 7/18, H05K 7/20, B25F 5/00

(54) **ELEKTRONIKEINHEIT**
ELECTRONIC UNIT
UNITÉ ÉLECTRONIQUE

(30) Priorität: 04.05.2018 DE 102018110754
(43) Veröffentlichungstag der Anmeldung: 06.11.2019
(73) Patentinhaber: C. & E. Fein GmbH, 73529 Schwäbisch Gmünd-Bargau (DE)
(72) Erfinder: Wohlfrom, Christoph, 73529 Schwäbisch Gmünd-Bargau (DE); Dürnegger, Wolfgang, 73529 Schwäbisch Gmünd-Bargau (DE)
(74) Vertreter: Wallinger, Michael

(56) Entgegenhaltungen:
- US-A1- 2013 092 431
- US-A1- 2014 233 204
- US-A1- 2016 295 740

## Beschreibung

Die Erfindung betrifft eine Elektronikeinheit für eine Handwerkzeugmaschine, mit einem Montagerahmen, der einen Aufnahmeraum aufweist, in den eine eine Mehrzahl von Elektronikbauteilen tragende Leiterplatte eingesetzt ist, sowie mit mindestens einem Kühlkörper zur Wärmeabfuhr von an den Elektronikbauteilen auftretender Verlustwärme.

Eine derartige Elektronikeinheit ist beispielsweise aus der WO 2017/173000 A1 bekannt, bei der die Elektronikbauteile auf der Leiterplatte verlötet sind. Bei der Montage müssen die Elektronikbauteile zunächst einzeln auf die Leiterplatte aufgesetzt werden, bevor diese mit der Leiterplatte verlötet werden können. Hiermit ist ein relativ hoher Montageaufwand verbunden, was sich nachteilig auf die Herstellungsdauer und damit auch auf die Herstellungskosten der Elektronikeinheit auswirkt. Zudem weisen die bei der WO 2017/173000 A1 verwendeten Kühlkörper, die zur Wärmeabfuhr der auftretenden Verlustwärme vorgesehen sind, Befestigungsabschnitte auf, die senkrecht auf der Leiterplatte befestigt sind, während die eigentlichen Kühlkörper nicht unmittelbar die Elektronikbauteile kontaktieren. Dies birgt den weiteren Nachteil, dass hierdurch die Kühlung der Elektronikbauteile nur eingeschränkt gegeben ist.

Die US 2013/092431 zeigt eine Aufnahme für eine Elektronik, mit der ein Teil der Elektronik vom Kühlluftstrom getrennt und vor Verunreinigungen geschützt werden soll. Bei der US 2013/092431 sind in der Aufnahme Öffnungen ausgebildet, durch die die Kühlelemente oder die Elektronikbauteile hindurchragen, die dem Kühlluftstrom ausgesetzt werden sollen. Die Montage dieser Elektronikbauteile ist dabei sehr aufwändig.

Die US 2014/0233204 A1 zeigt eine Elektronik eines elektrisch betriebenen Kraftfahrzeuges, bei der die Aufnahme der Elektronikbauteile aktiv durch eine Wasserkühlung gekühlt wird, was sehr aufwändig ist.

Die aus der US 2016/0295740 A1 bekannte Elektronik, wird ebenfalls bei einem Kraftfahrzeug eingesetzt. Hierbei sind auf einer Seite der Elektronik Bauteile verbaut, die relativ hoch sind. Zur Kühlung dieser Bauteile sind Kühlkörper vorgesehen, die auf der Seite der Platine angeordnet sind, auf der auch die hohen Bauteile montiert sind.

Der Erfindung liegt daher die Aufgabe zugrunde, die oben genannten Nachteile zu reduzieren und eine Elektronikeinheit für eine Handwerkzeugmaschine bereitzustellen, die eine einfache Montage und eine verbesserte Kühlung gewährleistet.

Diese Aufgabe wird gemäß der Erfindung bei einer Elektronikeinheit der eingangs genannten Art dadurch gelöst, dass an dem Montagerahmen ein Schachtabschnitt mit mindestens einem senkrecht zu der Leiterplatte orientierten Einschubschacht ausgebildet ist zur Aufnahme eines Elektronikbauteils entlang einer von der Leiterplatte wegweisenden Einschubrichtung, wobei die Form und die Höhe des mindestens einen Einschubschachts (9) an das darin aufgenommene Elektronikbauteil (5) angepasst ist, und dass der mindestens eine Kühlkörper dem Schachtabschnitt zugeordnet ist.

Hierdurch wird die Montage der Elektronikeinheit deutlich vereinfacht. So können Elektronikbauteile, die entweder schwer zu befestigen sind oder viel Verlustwärme erzeugen beziehungsweise besonders temperaturempfindlich sind - insbesondere MOSFETs - zunächst in die Einschubschächte eingeschoben werden, die in dem Schachtabschnitt des Montagerahmens ausgebildet sind. In einem nächsten Schritt wird dann die Leiterplatte, die mit weiteren Elektronikbauteilen bestückt sein kann, in den Aufnahmeraum eingesetzt. Dabei ist es im Rahmen der Erfindung vorgesehen, dass hierbei die Anschlusskontakte, die an den in den Einschubschächten aufgenommenen Elektronikbauteilen ausgebildet sind, durch Bohrungen durchgeführt werden, die in der Leiterplatte ausgebildet sind. Die in den Einschubschächten aufgenommenen Elektronikbauteile können anschließend an den mindestens einen Kühlkörper durch geeignete Koppelelemente - wie beispielsweise Wärmeleitpaste, Wärmeleitpads oder Wärmeleitbänder - thermisch angebunden und fest mit diesem verbunden werden, beispielsweise durch eine Schraub- und/oder Nietverbindung. Danach ist es möglich, die in den Einschubschächten aufgenommenen Elektronikbauteile beispielsweise durch eine Lötverbindung auf der dem Schachtabschnitt abweisenden Seite der Leiterplatte zu befestigen. Die Befestigung der Elektronikbauteile an den Kühlkörper vor dem eigentlichen Verlöten der Elektronikbauteile mit der Leiterplatte hat den Vorteil, dass deren Lage innerhalb der Einschubschächte und relativ zu der eingesetzten Leiterplatte festgelegt ist. Hierdurch werden zusätzliche Querkräfte und Belastungen auf die Elektronikbauteile und auf die Lötverbindung vermieden. Dies bewirkt damit, dass die Lötverbindung selbst frei von zusätzlichen mechanischen Beanspruchungen ist, wodurch letztlich auch die mechanische Belastung der Elektronikbauteile reduziert und dadurch die Lebensdauer der Elektronikbauteile gesteigert werden kann. Letztlich wird durch die Zuordnung des mindestens einen Kühlkörpers zu dem Schachtabschnitt auch gewährleistet, dass die Verlustwärme der in den Einschubschächten aufgenommenen Elektronikbauteile besonders effektiv abgeführt wird, da hierdurch die Kontaktfläche zwischen den Kühlkörpern und den Elektronikbauteilen, die in dem mindestens einen Einschubschacht aufgenommen sind, vergrößert wird. Der Schachtabschnitt kann dabei entweder als ein separates Bauteil oder besonders bevorzugt einstückig mit dem Montagerahmen gebildet sein.

Um die Kühlleistung der erfindungsgemäßen Elektronikeinheit weiter zu verbessern, hat es sich im Rahmen der Erfindung bewährt, wenn mehrere Kühlkörper vorgesehen sind, die an gegenüberliegenden Stirnseiten des Schachtabschnitts angeordnet sind. Hierdurch stehen die Kühlkörper in unmittelbarem Kontakt mit den zu kühlenden Elektronikbauteilen, die in den Einschubschächten aufgenommen sind. Zudem werden diese Elektronikbauteile durch die beiderseitig an dem Schachtabschnitt angeordneten Kühlkörper auch vor mechanischen Einflüssen, Verunreinigungen aus dem Arbeitsumfeld der Handwerkzeugmaschine und damit letztlich vor Beschädigungen geschützt. Um hierbei einen verbesserten Wärmetransport zu gewährleisten, hat es sich zudem auch als günstig erwiesen, wenn zwischen den in den Einschubschächten aufgenommenen Elektronikbauteilen und den Kühlkörpern ein Wärmeleitpad angeordnet ist.

Eine möglichst kompakte Gestaltung der Elektronikeinheit wird dadurch erreicht, dass der mindestens eine Einschubschacht mehrfach vorgesehen ist, und wenn die Einschubschächte in einer ersten Reihe und in einer zweiten Reihe angeordnet sind, die durch einen Separator voneinander beabstandet sind. Durch den Separator wird dabei verhindert, dass sich die in der ersten Reihe und in der zweiten Reihe befindlichen Elektronikbauteile in unerwünschter Weise berühren.

Als günstig hat es sich auch gezeigt, wenn an dem Schachtabschnitt Kopplungsstrukturen ausgebildet sind, die mit an dem mindestens einen Kühlkörper ausgebildeten Gegenstrukturen wechselwirken. Hierdurch können die Kühlkörper einfach mit dem Schachtabschnitt verbunden werden, was sich positiv auf den Montageaufwand der erfindungsgemäßen Elektronikeinheit auswirkt. Insbesondere wird hierdurch ein Formschluss zwischen dem Kühlkörper und dem Schachtabschnitt gebildet, wodurch die in den Einschubschächten aufgenommenen Elektronikbauteile von den Kühlkörpern bedeckt und damit geschützt werden. Hierbei ist es vorgesehen, dass der Kühlkörper mit seiner Gegenstruktur auf die Kopplungsstruktur aufgeklipst wird. Bevorzugt ist es dabei auch, wenn die Kopplungsstrukturen an den Stirnseiten des Schachtabschnitts ausgebildet sind.

Als besonders vorteilhaft hat es sich zudem auch gezeigt, wenn gegenüberliegende Kühlkörper durch ein Befestigungsmittel miteinander verbunden sind, das ausgewählt ist aus einer Gruppe, die Schrauben, Nieten, Klammer, formschlüssige sowie federnd vorgespannte Koppelelemente und Verklebungen umfasst. Hierdurch lassen sich die gegenüberliegenden Kühlkörper fest miteinander verbinden, wodurch die in den Einschubschächten aufgenommenen Elektronikbauteile von den Kühlkörpern gekapselt und vor äußeren Einflüssen geschützt sind. In diesem Zusammenhang hat es sich ebenfalls als günstig gezeigt, wenn in dem Schachtabschnitt quer zu der Einschubrichtung eine Durchführung ausgebildet ist, durch die das Befestigungsmittel durchgeführt ist. Somit kann bei der Montage beispielsweise die als Befestigungsmittel dienende Schraube durch die Kühlkörper und durch die in dem Schachtabschnitt ausgebildete Durchführung durchgeführt und verschraubt werden. Wenn die in den Einschubschächten aufgenommenen Elektronikbauteile dabei auch Durchführungen aufweisen, lassen sich diese besonders einfach mit den Kühlkörpern zu einer Einheit verbinden.

Um die übrigen Elektronikbauteile, die auf der Leiterplatte befestigt sind, zu schützen, hat es sich zudem als vorteilhaft erwiesen, wenn eine Vergussmaske vorgesehen ist, durch die auf der Leiterplatte mindestens ein Vergussbereich, der durch eine Vergussmasse vergießbar ist, und mindestens ein vergussmassenfreier Bereich definiert sind. Durch die Verwendung der Vergussmasse, die beispielsweise auf Epoxid, Silikon, Polyurethan oder Polyester basiert, wird erreicht, dass die auf der Leiterplatte befindlichen Elektronikbauteile vor mechanischen Beschädigungen und vor Verunreinigungen aus dem Arbeitsumfeld der Handwerkzeugmaschine, insbesondere vor elektrisch leitfähigen Metallstäuben, geschützt sind, wobei durch die Vergussmaske letztlich sichergestellt wird, dass nur die Bereiche von der Vergussmasse bedeckt werden, die durch die Vergussmaske nicht ausgespart sind. Die Vergussmaske weist dabei Stege mit unterschiedlichen Höhen auf, die derart ausgestaltet sind, dass nur die Stege der Vergussmaske auf der Leiterplatte aufliegen, durch die die vergussmassenfreien Bereiche definiert werden. Hierzu zählen insbesondere Kontaktstellen für den Anschluss von Kabeln. Beim Vergießen der Leiterplatte fließt die Vergussmasse unter den übrigen Stegen und Abschnitten, wodurch der Vergussbereich definiert wird. Der Montagerahmen weist dabei einen erhöhten Rand auf, durch den die Füllhöhe der Vergussmasse beschränkt wird. Im Rahmen der Erfindung ist es dabei insbesondere auch vorgesehen, dass mehrere Vergussbereiche definiert werden.

Als günstig hat es sich weiterhin gezeigt, wenn der Vergussmaske Referenzgeometrien zugeordnet sind, die die Ausrichtung der Vergussmaske relativ zu der Leiterplatte definieren. Hierdurch muss bei der Montage die Vergussmaske lediglich so zu der Leiterplatte ausgerichtet werden, dass die Referenzgeometrien in die korrespondierenden Strukturen - beispielsweise Öffnungen - eingreifen können, die auf der Leiterplatte ausgebildet sind. Weiterhin hat es sich in diesem Zusammenhang auch bewährt, wenn die Vergussmaske Stützelemente aufweist zur Abstützung der Vergussmaske auf der Leiterplatte und/oder auf dem Montagerahmen, wodurch das Vergießen der Leiterplatte mit der Vergussmasse begünstigt wird.

Um die Verbindung zwischen der Vergussmaske und der Leiterplatte zu erleichtern, hat es sich zudem als vorteilhaft erwiesen, wenn an den Referenzgeometrien und/oder an den Stützelementen Verankerungsnasen ausgebildet sind. Die Verankerungsnasen werden beim Vergießen der Leiterplatte mit der Vergussmasse in diese eingebettet, wodurch die Vergussmaske fest mit der Leiterplatte verbunden wird.

Bewährt hat es sich zudem auch, wenn der Montagerahmen eine Aufnahme aufweist, deren Aufnahmeöffnung senkrecht zu der Einschubrichtung des mindestens einen Einschubschachts orientiert ist. In dieser Aufnahme wird ein Aufnahmeraum bereitgestellt, in den beispielsweise ein Kondensator oder andere relativ große Elektronikbauteile eingesetzt werden können und der von der Leiterplatte letztlich axial beabstandet ist, wodurch Bauraum auf der Leiterplatte erzeugt wird, um darauf andere Elektronikbauteile befestigen zu können.

Die Kühlung der Elektronikeinheit kann verbessert werden, wenn der Montagerahmen einen T-förmigen Querschnitt aufweist, und wenn der mindestens eine Schachtabschnitt mittig zu dem Aufnahmeraum angeordnet ist. Durch den daraus resultierenden symmetrischen Aufbau der Elektronikeinheit wird die Verlustwärme von der die Kühlkörper umströmenden Kühlluft besonders effektiv abgeleitet.

Als günstig hat es sich zudem gezeigt, wenn ein Schalterhalter vorgesehen ist, mit einer Schalterführung, auf die ein Schalter aufgesetzt werden kann. Der Schalterhalter kann dabei insbesondere an der Vergussmaske ausgebildet sein. Hierdurch muss bei der Montage der Elektronikeinheit lediglich der Schalter, der beispielsweise als ein Ein/Aus-Schalter dient, in die Schalterführung des Schalterhalters eingesetzt und dort befestigt werden, sodass dessen Lage auf der Elektronikeinheit festgelegt ist. Bei der Montage bewirkt dies den Vorteil, dass die Elektronikeinheit als Einheit mitsamt dem Schalter verbaut werden kann. In diesem Zusammenhang hat es sich auch bewährt, wenn an dem Montagerahmen eine einen Durchbruch aufweisende Schalteraufnahme ausgebildet ist zur Aufnahme eines Drehschalters, mit dem sich die Antriebseigenschaften der Handwerkzeugmaschine verändern lassen. Auch dies wirkt sich positiv auf den Montageaufwand aus, da somit die komplette Elektronikeinheit vollständig - also mit dem Ein/Aus-Schalter und mit dem Drehschalter - vormontiert und in die Werkzeugmaschine eingesetzt werden kann. Hierbei hat es sich auch als besonders vorteilhaft erwiesen, wenn an dem Montagerahmen außenumfangsseitig ein Kopplungsabschnitt ausgebildet ist, der geeignet ist, mit einem Maschinengehäuse einer Handwerkzeugmaschine gekoppelt zu werden. Hierdurch wird die Anordnung der Elektronikeinheit innerhalb der Handwerkzeugmaschine festgelegt, sodass diese bei der Montage in das Maschinengehäuse der Handwerkzeugmaschine eingesetzt werden kann.

Im Rahmen der Erfindung ist es hierbei vorgesehen, dass die Form der Einschubschächte an die Gestalt der Elektronikbauteile angepasst ist, die dazu vorgesehen sind, in den Einschubschächten aufgenommen zu werden, wodurch eine passende Ausrichtung der in den Einschubschächten aufgenommenen Elektronikbauteile relativ zu der in dem Aufnahmeraum befindlichen Leiterplatte erreicht wird. Dabei sind die Höhen der Einschubschächte an die jeweiligen Elektronikbauteile angepasst.

Bewährt hat es sich zudem wenn, auf der Leiterplatte selbstschneidende Anschlusskontakte vorgesehen sind zum Anschließen unkonfektionierter Anschlusslitzen eines Antriebs einer Handwerkzeugmaschine. Somit können mittels einer "Push-In"-Kontaktierung die Anschlusslitzen des elektrischen Antriebs einer Handwerkzeugmaschine einfach in die selbstschneidenden Anschlusskontakte eingesetzt werden. Hierbei wird die Isolierung lokal entfernt und die Litze in dem Anschlusskontakt geklemmt und gleichzeitig elektrisch kontaktiert. Dies stellt eine einfache Art der Kontaktierung dar, bei der auf die Verwendung vorgelängter Kabel sowie auf spezielle Kabelanschlüsse verzichtet werden kann.

Von der Erfindung ist insbesondere auch eine Handwerkzeugmaschine mit einer erfindungsgemäßen Elektronikeinheit umfasst.

Im Folgenden wird die Erfindung an einem in den Zeichnungen dargestellten Ausführungsbeispiel näher erläutert; es zeigen:
- Fig. 1: eine perspektivische Ansicht einer Elektronikeinheit,
- Fig. 2: eine perspektivische Schnittansicht durch die Elektronikeinheit,
- Fig. 3: eine perspektivische Ansicht eines Montagerahmens, und
- Fig. 4: eine perspektivische Ansicht einer Vergussmaske der Elektronikeinheit.

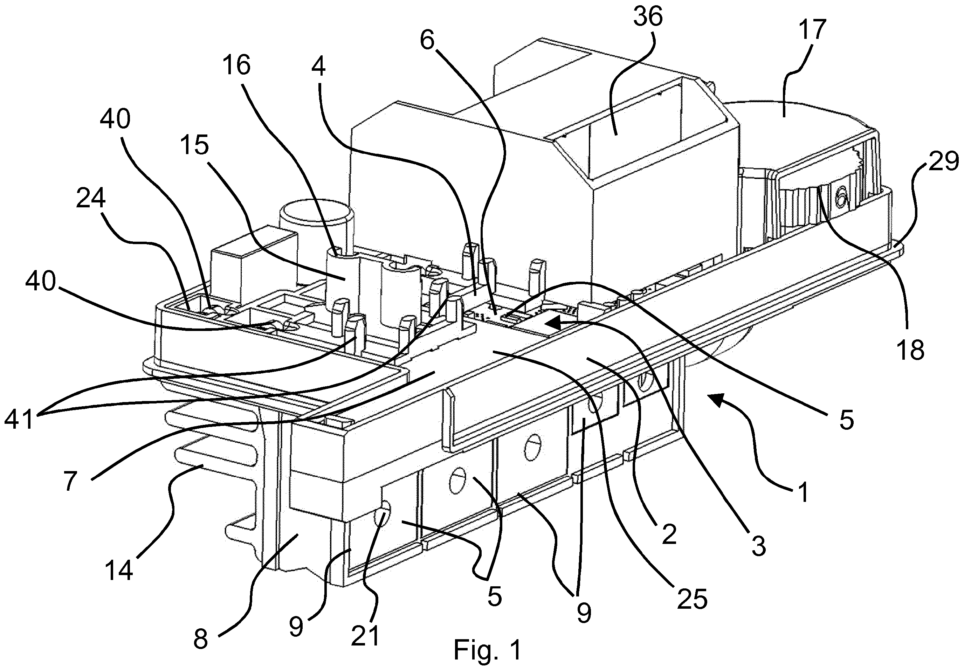

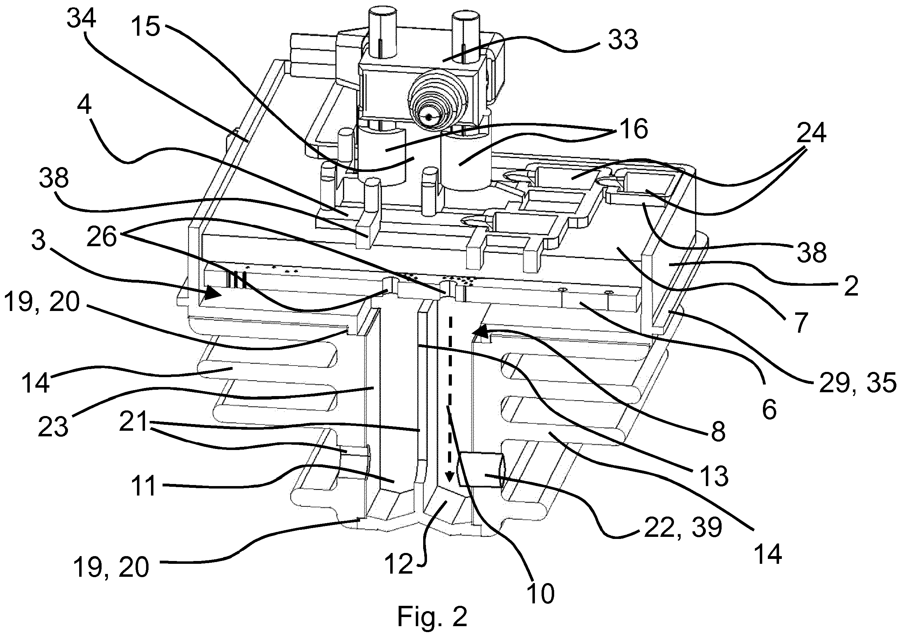

Figur 1 zeigt in einer perspektivischen Ansicht eine Elektronikeinheit 1 für eine Handwerkzeugmaschine. Die Elektronikeinheit 1 weist dabei einen Montagerahmen 2, der einen Aufnahmeraum 3 umfasst, und eine Vergussmaske 4 auf. In dem Aufnahmeraum 3 ist eine eine Mehrzahl von Elektronikbauteilen 5 tragende Leiterplatte 6 eingesetzt, wobei ein Teil der Elektronikbauteile 5 auf der Leiterplatte 6 durch eine Vergussmasse 7 vergossen und damit vor mechanischen Beschädigungen und vor Verunreinigungen aus dem Arbeitsumfeld der Handwerkzeugmaschine, insbesondere vor elektrisch leitfähigen Metallstäuben, geschützt ist. An dem Montagerahmen 2 ist ein Schachtabschnitt 8 mit mehreren Einschubschächten 9 ausgebildet, die senkrecht zu der Leiterplatte 6 orientiert sind. In die Einschubschächte 9 sind dabei weitere Elektronikbauteile 5 entlang einer Einschubrichtung 10 eingeschoben. Die Einschubschächte 9 sind in dem gezeigten Ausgangsbeispiel in einer ersten Reihe 11 und in einer zweiten Reihe 12 angeordnet, die durch einen Separator 13 voneinander getrennt sind, der insbesondere aus der Figur 2 ersichtlich ist. An gegenüberliegenden Stirnseiten des Schachtabschnitts 8 sind Kühlkörper 14 angebracht, die in thermischem Kontakt mit den in den Einschubschächten 9 aufgenommenen Elektronikbauteilen 5 stehen. In der Figur 1 ist dabei lediglich einer der Kühlkörper 14 dargestellt, während auf die Darstellung des anderen Kühlkörpers 14 aus Übersichtsgründen verzichtet wurde, um die in den Einschubschächten 9 aufgenommenen Elektronikbauteile 5 darstellen zu können. An der Vergussmaske 4 ist ein Schalterhalter 15 ausgebildet, der eine Schalterführung 16 aufweist, auf die bei der Montage ein Schalter 33 aufgesetzt werden kann. Der Figur 1 ist weiterhin auch eine Schalteraufnahme 17 zu entnehmen, in der ein Drehschalter 18 aufgenommen ist, mit dem es dem Nutzer ermöglicht ist, die Motorcharakteristik der Handwerkzeugmaschine zu verändern. Zudem ist an der Vergussmaske 4 eine Aufnahme 36 ausgebildet, in die beispielsweise ein Kondensator eingesetzt werden kann. Auch sind selbstschneidende Anschlusskontakte 40 zu erkennen, in die Litzen eines Antriebs einer Handwerkzeugmaschine eingesetzt werden können, wie nachstehend noch näher beschrieben wird. Diese Litzen können dann in Kabelführungen 41 gesichert werden, die an der Vergussmaske 4 ausgebildet sind.

Figur 2 zeigt eine perspektivische Schnittansicht durch die Elektronikeinheit 1. Hierbei ist insbesondere die in dem Aufnahmeraum 3 des Montagerahmens 2 befindliche Leiterplatte 6 zu erkennen, in der die Vergussmaske 4 eingesetzt ist. Zur besseren Übersichtlichkeit wird dabei auf die Darstellung der Elektronikbauteile 5 verzichtet. Der Schnittansicht der Figur 2 kann insbesondere entnommen werden, dass der Montagerahmen 2 einen T-förmigen Querschnitt aufweist und dass der Schachtabschnitt 8 mittig zu dem Aufnahmeraum 3 angeordnet ist. Aus der Figur 2 wird zudem auch noch einmal die Anordnung der Kühlkörper 14 deutlich, die an gegenüberliegenden Stirnseiten des Schachtabschnitts 8 angeordnet sind. Um dabei die Montage der Kühlkörper 14 an dem Montagerahmen 2 zu vereinfachen, sind an dem Schachtabschnitt 8 im Bereich der Stirnseiten Kopplungsstrukturen 19 ausgebildet, die mit an dem Kühlkörper 14 ausgebildeten Gegenstrukturen 20 im Eingriff stehen. In den Kühlkörpern 14 sowie in dem Separator 13, der die erste Reihe 11 der Einschubschächte 9 von der zweiten Reihe 12 trennt, sind Durchführungen 21 ausgebildet, die eine als ein Befestigungsmittel 22 dienende Schraubverbindung 39 aufnehmen, um die in den Einschubschächten 9 aufgenommenen Elektronikbauteile 5 durch die Kühlkörper 14 zu kapseln, wobei die Elektronikbauteile 5 ebenfalls Durchführungen 21 aufweisen können. Zwischen den Kühlkörper 14 und den Elektronikbauteilen 5 ist dabei ein Wärmeleitpad 23 angebracht, um den Wärmeübertrag auf die Kühlkörper 14 zu verbessern. Die Vergussmaske 4 weist unterschiedliche Bereiche auf, die sich in ihrer Höhe unterscheiden. In Bereichen der Stege 38, bei denen die Vergussmaske 4 unmittelbar auf der Leiterplatte 6 aufliegt, werden vergussmassenfreie Bereiche 24 definiert, die beim Vergießen der Elektronikbauteile 5 durch die Vergussmasse 7 frei bleiben. In den Bereichen hingegen, in denen die Stege 38 der Vergussmaske 4 nicht unmittelbar auf der Leiterplatte 6 aufliegen, werden Vergussbereiche 25 definiert, die beim Eingießen der Vergussmasse 7 mit dieser gefüllt werden, um die darin befindlichen elektronischen Bauteile 5 vor mechanischen Beschädigungen und vor Verunreinigungen aus dem Arbeitsumfeld der Handwerkzeugmaschine, insbesondere vor elektrisch leitfähigen Metallstäuben, zu schützen. Zudem sind in der Schnittansicht in der Leiterplatte 6 Bohrungen 26 zu erkennen, durch die die Anschlusspins der in den Einschubschächten 9 befindlichen Elektronikbauteile 5 durch die Leiterplatte 6 hindurch auf die Oberseite der Leiterplatte 6 geführt werden, um diese dort zu verlöten. Die Einschubschächte 9 weisen dabei, insbesondere im Bodenbereich, eine an die Form der darin befindlichen Elektronikbauteile 5 angepasste Gestalt auf, wodurch die Montage dieser Elektronikbauteile 5 begünstigt wird.

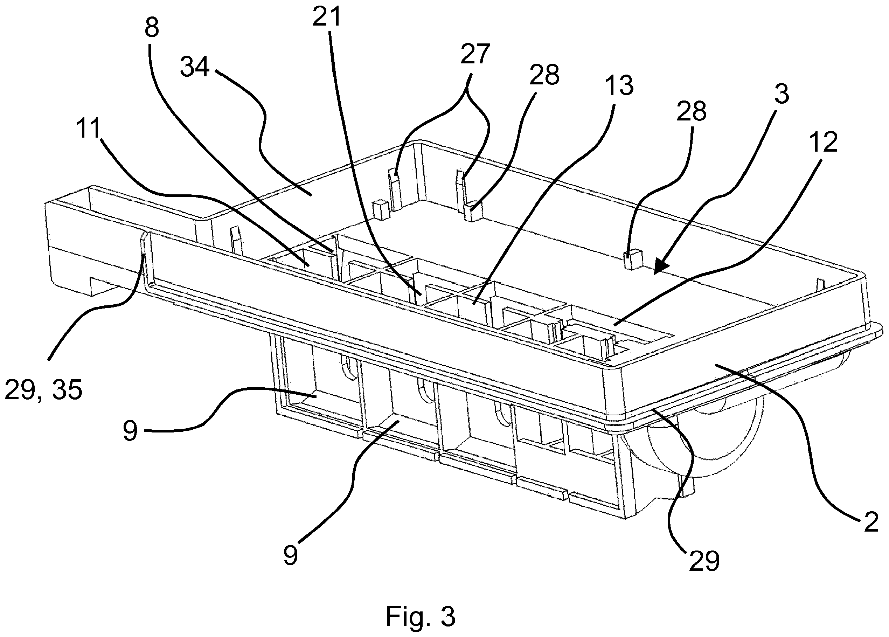

Figur 3 zeigt in einer perspektivischen Ansicht den Montagerahmen 2. Hierbei sind insbesondere Einführschrägen 27 erkennbar, die das Einsetzen der Leiterplatte 6 in den Aufnahmeraum 3 begünstigen. Weiterhin sind in dem Aufnahmeraum 3 auch Auflagen 28 ausgebildet, auf denen die Leiterplatte 6 im montierten Zustand aufliegt, und die die axiale Position der Leiterplatte 6 in dem Aufnahmeraum 3 festlegen. Diese sind dabei derartig dimensioniert, dass bei aufgelegter Leiterplatte 6 noch ein ausreichend hoher Rand 34 vorhanden ist, um die Vergussmasse 7 auf die Leiterplatte 6 zu gießen. An dem Montagerahmen 2 sind außenumfangsseitig Kopplungsabschnitte 29 ausgebildet, die es ermöglichen, die Elektronikeinheit 1 mit einem Maschinengehäuse einer Handwerkzeugmaschine zu koppeln. Die Kopplungsabschnitte 29 sind dabei als zumindest teilweise umlaufender Bund 35 gebildet.

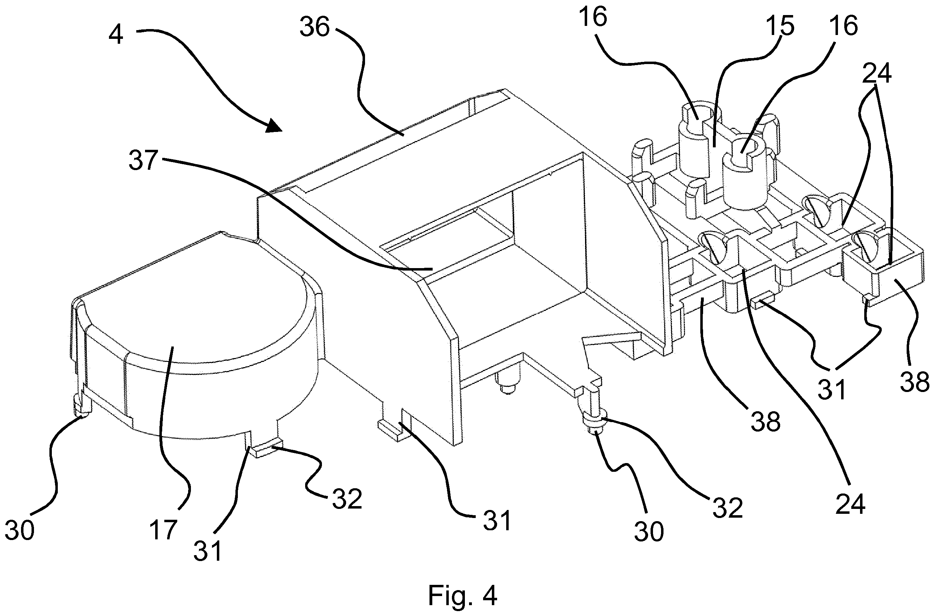

Figur 4 zeigt ebenfalls in einer perspektivischen Ansicht die Vergussmaske 4 der erfindungsgemäßen Elektronikeinheit 1. Neben der unterschiedlichen Höhe der Stege 38 der Vergussmaske 4, durch die der mindestens eine vergussmassenfreie Bereich 24 und der Vergussbereich 25 gebildet werden, sind in der Figur 4 insbesondere die Schalteraufnahme 17 für den Drehschalter 18 sowie der Schalterhalter 15 mit der Schalterführung 16 zu erkennen. An der Unterseite - also der der Leiterplatte 6 zugewandten Seite - der Vergussmaske 4 sind Referenzgeometrien 30 ausgebildet, die die Ausrichtung der Vergussmaske 4 relativ zu der Leiterplatte 6 definieren. Zudem weist die Vergussmaske 4 Stützelemente 31 auf, die der Abstützung der Vergussmaske 4 auf der Leiterplatte 6 dienen. Um das Vergießen der Vergussmaske 4 in die Vergussmasse 7 zu erleichtern, sind in dem gezeigten Ausgangsbeispiel an den Referenzgeometrien 30 und an den Stützelementen 31 Verankerungsnasen 32 ausgebildet, die beim Eingießen der Vergussmasse 7 auf die Leiterplatte 6 in dieser eingebettet werden, sodass letztlich die Oberfläche der Kontaktstellen der Vergussmaske 4, die von der Vergussmasse 7 eingebettet werden, vergrößert wird, was zu einer verbesserten Verbindung der Vergussmaske 4 mit der Vergussmasse 7 führt. Letztlich ist der Figur 4 auch die Aufnahme 36 zu entnehmen, die der Aufnahme eines Kondensators dient. Die Aufnahmeöffnung 37 der Aufnahme 36 ist dabei senkrecht zu der Einschubrichtung 10 der Einschubschächte 9 orientiert.

Im Folgenden wird die Montage der erfindungsgemäßen Elektronikeinheit 1 noch einmal näher beschrieben. Zunächst wird in die Einschubschächte 9 des an dem Montagerahmen 2 ausgebildeten Schachtabschnitts 8 ein Teil der Elektronikbauteile 5 eingesetzt. Durch die Kühlkörper 14 werden diese Elektronikbauteile 5 in den Einschubschächten 9 geschützt und zu einer Einheit verbunden. Zudem lassen sich die in den Einschubschächten 9 aufgenommenen Elektronikbauteile 5 durch das durch die Kühlkörper 14 durchgeführte Befestigungsmittel 22 fixieren. Sodann wird die vorkonfektionierte Leiterplatte 6 in den Aufnahmeraum 3 eingesetzt, wobei die Anschlusskontakte der in den Einschubschächten 9 aufgenommenen Elektronikbauteile 5 durch die Bohrungen 26 hindurchtreten, die in der Leiterplatte 6 ausgebildet sind, so dass die Anschlusskontakte auf der Leiterplatte 6 verlötet werden können. Bei dem Aufsetzen der Leiterplatte 6 in den Aufnahmeraum 3 wird mittels Einführschrägen 27 und Auflagen 28, die an dem Montagerahmen 2 ausgebildet sind, die Positionierung der Leiterplatte 6 relativ zu dem Montagerahmen 2 erleichtert. Anschließend werden die Elektronikbauteile 5 mit der Leiterplatte 6 verlötet. In einem weiteren Schritt wird die Vergussmaske 4 auf die in dem Aufnahmeraum 3 befindliche Leiterplatte 6 aufgesetzt. Um hier auch die Positionierung der Vergussmaske 4 relativ zu der Leiterplatte 6 zu erleichtern, sind an der Vergussmaske 4 Referenzgeometrien 30 ausgebildet, die in korrespondierende Öffnungen eingreifen, die auf der Oberfläche der Leiterplatte 6 ausgebildet sind. Zudem weist die Vergussmaske 4 die Stützelemente 31 auf, mit denen sich die Vergussmaske 4 auf der Leiterplatte 6 abstützt. Durch die Vergussmaske 4 werden dabei vergussmassenfreie Bereiche 24 und Vergussbereiche 25 definiert. Wird nun eine Vergussmasse 7 - beispielsweise Epoxidharz - auf die Leiterplatte 6 gegossen, so fließt dieses - begrenzt durch den Rand 34 des Montagerahmens 2 - in die Vergussbereiche 25, die durch die Vergussmaske 4 definiert sind, während die Vergussmasse 7 nicht in die vergussmassenfreien Bereiche 24 strömt, da dort die Vergussmaske 4 auf der Leiterplatte 6 aufliegt und hiergegen abdichtet. Die Abdichtung zwischen der Leiterplatte 6 und der Vergussmaske 4 kann insbesondere durch das Aufbringen von Dicht- und Dichthilfsstoffen an die verwendete Vergussmasse 7 angepasst werden. Diese Stoffe können dabei insbesondere pastös sein und sollen ein Eindringen - beispielsweise ein Kriechen - der Vergussmasse 7 in die vergussmassenfreien Bereiche 24 verhindern. Dabei strömt die Vergussmasse 7 selbstverständlich in den Zwischenraum, der zwischen dem Rand 34 und der Leiterplatte 6 gebildet ist, und damit um die Leiterplatte 6 herum und in den Schachtabschnitt 8 hinein, in dem die Einschubschächte 9 ausgebildet sind. Hierdurch wird eine Einheit geschaffen, die durch die Vergussmasse 7, aber auch durch die Kühlkörper 14, in sich gekapselt ist und bei der auf der Leiterplatte 6 lediglich die vergussmassenfreien Bereiche 24 der Vergussmaske 4 zugänglich sind. Der Schalter 33 kann nun auf den Schalterhalter 15 aufgesetzt und dort beispielsweise durch eine Rastverbindung gesichert werden. Nachdem die übrigen Elektronikbauteile 5 angeschlossen sind, kann die Elektronikeinheit 1 in einer Handwerkzeugmaschine - beispielsweise in einem Winkelschleifer - verbaut werden. Hierbei haben sich folgende Montageschritt als günstig gezeigt. Zuerst wird in einem ersten Schritt die Elektronikeinheit 1 in die Handwerkzeugmaschine einsetzen, wobei sich durch den Kopplungsabschnitt 29, der außenumfangsseitig an dem Montagerahmen 2 ausgebildet ist, die Position der Elektronikeinheit 1 in der Handwerkzeugmaschine festlegen lässt. Zu diesem Zweck ist in der Handwerkzeugmaschine eine korrespondierende Struktur ausgebildet, die mit dem Kopplungsabschnitt 29 wechselwirkt, der in dem gezeigten Ausführungsbeispiel als umlaufender Bund 35 gebildet ist. In einem zweiten Schritt werden dann die unkonfektionierten Litzen des Antriebs der Handwerkzeugmaschine an die auf der Platine 6 in vergussmassenfreien Bereichen 24 angeordneten Anschlusskontakte 40 angeschlossen. Diese sind selbstschneidend ausgelegt, so dass beim Einsetzen der Litzen in die Anschlusskontakte 40 die Isolierungen der unkonfektionierten Litzen lokal entfernt werden, diese simultan geklemmt und damit elektrisch kontaktiert werden. Die Litzen werden dann in die Kabelführungen 41 aufgenommen und dadurch zusätzlich gesichert, die an der Vergussmaske 4 ausgebildet sind.

### Bezugszeichenliste

- 1: Elektronikeinheit
- 2: Montagerahmen
- 3: Aufnahmeraum
- 4: Vergussmaske
- 5: Elektronikbauteil
- 6: Leiterplatte
- 7: Vergussmasse
- 8: Schachtabschnitt
- 9: Einschubschacht
- 10: Einschubrichtung
- 11: erste Reihe
- 12: zweite Reihe
- 13: Separator
- 14: Kühlkörper
- 15: Schalterhalter
- 16: Schalterführung
- 17: Schalteraufnahme
- 18: Drehschalter
- 19: Kopplungsstruktur
- 20: Gegenstruktur
- 21: Durchführung
- 22: Befestigungsmittel
- 23: Wärmeleitpad
- 24: vergussmassenfreier Bereich
- 25: Vergussbereich
- 26: Bohrung
- 27: Einführschräge
- 28: Auflage
- 29: Kopplungsabschnitt
- 30: Referenzgeometrie
- 31: Stützelement
- 32: Verankerungsnase
- 33: Schalter
- 34: Rand
- 35: Bund
- 36: Aufnahme
- 37: Aufnahmeöffnung
- 38: Steg
- 39: Schraubverbindung
- 40: Anschlusskontakt
- 41: Kabelführung

## Patentansprüche

1. Elektronikeinheit (1) für eine Handwerkzeugmaschine, mit einem Montagerahmen (2), der einen Aufnahmeraum (3) aufweist, in den eine eine Mehrzahl von Elektronikbauteilen (5) tragende Leiterplatte (6) eingesetzt ist, sowie mit mindestens einem Kühlkörper (14) zur Wärmeabfuhr von an den Elektronikbauteilen (5) auftretender Verlustwärme, **dadurch gekennzeichnet, dass** an dem Montagerahmen (2) ein Schachtabschnitt (8) mit mindestens einem senkrecht zu der Leiterplatte (6) orientierten Einschubschacht (9) ausgebildet ist zur Aufnahme eines Elektronikbauteils (5) entlang einer von der Leiterplatte (6) wegweisenden Einschubrichtung (10), wobei die Form und die Höhe des mindestens einen Einschubschachts (9) an das darin aufgenommene Elektronikbauteil (5) angepasst ist, und dass der mindestens eine Kühlkörper (14) dem Schachtabschnitt (8) zugeordnet ist.

2. Elektronikeinheit (1) nach Anspruch 1, **dadurch gekennzeichnet, dass** mehrere Kühlkörper (14) vorgesehen sind, die an gegenüberliegenden Stirnseiten des Schachtabschnitts (8) angeordnet sind.

3. Elektronikeinheit (1) nach Anspruch 1 oder 2, **dadurch gekennzeichnet, dass** der mindestens eine Einschubschacht (9) mehrfach vorgesehen ist, und dass die Einschubschächte (9) in einer ersten Reihe (11) und in einer zweiten Reihe (12) angeordnet sind, die durch einen Separator (13) voneinander beabstandet sind.

4. Elektronikeinheit (1) nach einem der Ansprüche 1 bis 3, **dadurch gekennzeichnet, dass** an dem Schachtabschnitt (8) Kopplungsstrukturen (19) ausgebildet sind, die mit in an dem mindestens einen Kühlkörper (14) ausgebildeten Gegenstrukturen (20) wechselwirken.

5. Elektronikeinheit (1) nach einem der Ansprüche 2 bis 4, **dadurch gekennzeichnet, dass** gegenüberliegende Kühlkörper (14) durch ein Befestigungsmittel (22) miteinander verbunden sind, das ausgewählt ist aus einer Gruppe, die Schrauben, Nieten, Klammer, formschlüssige sowie federnd vorgespannte Koppelelemente und Verklebungen umfasst.

6. Elektronikeinheit (1) nach Anspruch 5, **dadurch gekennzeichnet, dass** in dem Schachtabschnitt (8) senkrecht zu der Einschubrichtung (10) eine Durchführung (21) ausgebildet ist, durch die das Befestigungsmittel (22) durchgeführt ist.

7. Elektronikeinheit (1) nach einem der Ansprüche 1 bis 6, **dadurch gekennzeichnet, dass** eine Vergussmaske (4) vorgesehen ist, durch die auf der Leiterplatte (6) mindestens ein Vergussbereich (25), der durch eine Vergussmasse (7) vergossen ist, und mindestens ein vergussmassenfreier Bereich (24) definiert sind.

8. Elektronikeinheit (1) nach Anspruch 7, **dadurch gekennzeichnet, dass** der Vergussmaske (4) Referenzgeometrien (30) zugeordnet sind, die die Ausrichtung der Vergussmaske (4) relativ zu der Leiterplatte (6) definieren.

9. Elektronikeinheit (1) nach Anspruch 7 oder 8, **dadurch gekennzeichnet, dass** die Vergussmaske (4) Stützelemente (31) aufweist zur Abstützung der Vergussmaske (4) auf der Leiterplatte (6) und/oder auf dem Montagerahmen (2).

10. Elektronikeinheit (1) nach Anspruch 8 oder 9, **dadurch gekennzeichnet, dass** an den Referenzgeometrien (30) und/oder an den Stützelementen (31) Verankerungsnasen (32) ausgebildet sind.

11. Elektronikeinheit (1) nach einem der Ansprüche 1 bis 10, **dadurch gekennzeichnet, dass** die Vergussmaske (4) eine Aufnahme (36) zur Aufnahme eine Kondensators aufweist, deren Aufnahmeöffnung (37) senkrecht zu der Einschubrichtung (10) des mindestens einen Einschubschachts (9) orientiert ist.

12. Elektronikeinheit (1) nach einem der Ansprüche 1 bis 11, **dadurch gekennzeichnet, dass** der Montagerahmen (2) einen T-förmigen Querschnitt aufweist, und dass der mindestens eine Schachtabschnitt (8) mittig zu dem Aufnahmeraum (3) angeordnet ist.

13. Elektronikeinheit (1) nach einem der Ansprüche 1 bis 12, **dadurch gekennzeichnet, dass** ein Schalterhalter (15) vorgesehen ist, mit einer Schalterführung (16), auf die ein Schalter (33) aufgesetzt werden kann.

14. Elektronikeinheit (1) nach einem der Ansprüche 1 bis 13, **dadurch gekennzeichnet, dass** an dem Montagerahmen (2) eine einen Durchbruch aufweisende Schalteraufnahme (17) ausgebildet ist zur Aufnahme eines die Antriebseigenschaften der Handwerkzeugmaschine verändernden Drehschalters (18).

15. Elektronikeinheit (1) nach einem der Ansprüche 1 bis 14, **dadurch gekennzeichnet, dass** an dem Montagerahmen (2) außenumfangsseitig ein Kopplungsabschnitt (29) ausgebildet ist, der geeignet ist, mit korrespondierenden Kopplungsgegenabschnitten eines Maschinengehäuses einer Handwerkzeugmaschine gekoppelt zu werden.

16. Elektronikeinheit (1) nach einem der Ansprüche 1 bis 15, **dadurch gekennzeichnet, dass** auf der Leiterplatte (7) selbstschneidende Anschlusskontakte (40) vorgesehen sind zum Anschließen unkonfektionierter Anschlusslitzen eines Antriebs einer Handwerkzeugmaschine.

## Claims

1. Electronic unit (1) for a hand-held machine tool, with a mounting frame (2) comprising a receiving space (3) into which a printed circuit board (6) carrying a plurality of electronic components (5) is inserted, and with at least one heat sink (14) for the dissipation of heat loss occurring at the electronic components (5), **characterized in that** a shaft section (8), with at least one insertion shaft (9) oriented perpendicularly to the printed circuit board (6), is formed on the mounting frame (2) for receiving an electronic component (5) along an insertion direction (10) pointing away from the printed circuit board (6), wherein the shape and the height of the at least one insertion shaft (9) is adapted to the electronic component (5) received therein, and **in that** the at least one heat sink (14) is assigned to the shaft section (8).

2. Electronic unit (1) according to claim 1, **characterized in that** a plurality of heat sinks (14) is provided, which is arranged on opposite end faces of the shaft section (8).

3. Electronic unit (1) according to claim 1 or 2, **characterized in that** the at least one insertion shaft (9) is provided multiple times, and **in that** the insertion shafts (9) are arranged in a first row (11) and in a second row (12), which are spaced apart by a separator (13).

4. Electronic unit (1) according to any one of claims 1 to 3, **characterized in that** coupling structures (19) are formed on the shaft section (8), which interact with counter structures (20) formed on the at least one heat sink (14).

5. Electronic unit (1) according to any one of claims 2 to 4, **characterized in that** opposing heat sinks (14) are connected to one another by a fastening means (22) which is selected from a group comprising screws, rivets, clips, positive-locking as well as resiliently prestressed coupling elements, and adhesions.

6. Electronic unit (1) according to claim 5, **characterized in that** in the shaft section (8) a passage (21) is formed perpendicular to the insertion direction (10), through which the fastening means (22) is passed through.

7. Electronic unit (1) according to any one of claims 1 to 6, **characterized in that** a potting mask (4) is provided, by means of which at least one potting region (25), which is potted by a potting compound (7), and at least one potting compound-free region (24) are defined on the printed circuit board (6).

8. Electronic unit (1) according to claim 7, **characterized in that** the potting mask (4) is assigned to reference geometries (30) which define the orientation of the potting mask (4) relative to the printed circuit board (6).

9. Electronic unit (1) according to claim 7 or 8, **characterized in that** the potting mask (4) comprises supporting elements (31) for supporting the potting mask (4) on the printed circuit board (6) and/or on the mounting frame (2).

10. Electronic unit (1) according to claim 8 or 9, **characterized in that** anchoring lugs (32) are formed on the reference geometries (30) and/or on the support elements (31).

11. Electronic unit (1) according to any one of the claims 1 to 10, **characterized in that** the potting mask (4) comprises a receptacle (36) for receiving a capacitor, wherein a receptacle opening (37) of which is oriented perpendicular to the insertion direction (10) of the at least one insertion shaft (9).

12. Electronic unit (1) according to any one of claims 1 to 11, **characterized in that** the mounting frame (2) comprises a T-shaped cross-section, and **in that** the at least one shaft section (8) is arranged centrally with respect to the receiving space (3).

13. Electronic unit (1) according to any one of claims 1 to 12, **characterized in that** a switch holder (15) is provided, with a switch guide (16) on which a switch (33) can be placed.

14. Electronic unit (1) according to any one of claims 1 to 13, **characterized in that** a switch receptacle (17) comprising an aperture is formed on the mounting frame (2) for receiving a rotary switch (18) which changes the drive characteristics of the hand-held machine tool.

15. Electronic unit (1) according to any one of the claims 1 to 14, **characterized in that** a coupling section (29) is formed on the outer circumference of the mounting frame (2), which is adapted for being coupled to corresponding coupling counter sections of a machine housing of a hand-held machine tool.

16. Electronic unit (1) according to any one of claims 1 to 15, **characterized in that** self-tapping connection contacts (40) are provided on the printed circuit board (7) for connecting unassembled pigtails of a drive of a hand-held machine tool.

## Revendications

1. Unité électronique (1) pour une machine-outil manuelle, avec un cadre de montage (2), qui présente un espace de logement (3), dans lequel est insérée une carte de circuits imprimés (6) supportant une multitude de composants électroniques (5), ainsi qu'avec au moins un corps de refroidissement (14) pour dissiper la chaleur d'une déperdition de chaleur survenant sur les composants électroniques (5), **caractérisée en ce qu'**une section de compartiment (8) avec au moins un compartiment d'insertion (9) orienté de manière perpendiculaire par rapport à la carte de circuits imprimés (6) est réalisée sur le cadre de montage (2) pour loger un composant électronique (5) le long d'une direction d'insertion (10) s'écartant de la carte de circuits imprimés (6), dans laquelle la forme et la hauteur de l'au moins un compartiment d'insertion (9) sont adaptées au composant électronique (5) qui y est logé, et que l'au moins un corps de refroidissement (14) est associé à la section de compartiment (8).

2. Unité électronique (1) selon la revendication 1, **caractérisée en ce que** sont prévus plusieurs corps de refroidissement (14), qui sont disposés sur des côtés frontaux se faisant face de la section de compartiment (8).

3. Unité électronique (1) selon la revendication 1 ou 2, **caractérisée en ce que** l'au moins un compartiment d'insertion (9) est prévu de manière multiple, et que les compartiments d'insertion (9) sont disposés en une première rangée (11) et en une deuxième rangée (12) qui sont tenues à distance l'une de l'autre par un séparateur (13) .

4. Unité électronique (1) selon l'une quelconque des revendications 1 à 3, **caractérisée** en e que sont réalisées sur la section de compartiment (8) des structures de couplage (19) qui interagissent avec des contre-structures (20) réalisées sur l'au moins un corps de refroidissement (14) .

5. Unité électronique (1) selon l'une quelconque des revendications 2 à 4, **caractérisée en ce que** des corps de refroidissement (14) se faisant face sont reliées les uns aux autres par un moyen de fixation (22) qui est choisi parmi un groupe qui comprend des vis, des rivets, des agrafes, des éléments de couplage à complémentarité de forme et précontraints de manière élastique et des collages.

6. Unité électronique (1) selon la revendication 5, **caractérisée en ce qu'**est réalisé dans la section de compartiment (8), de manière perpendiculaire par rapport à la direction d'insertion (10), un passage (21) à travers lequel le moyen de fixation (22) est guidé de part en part.

7. Unité électronique (1) selon l'une quelconque des revendications 1 à 6, **caractérisée en ce qu'**est prévu un masque de scellement (4), par lequel au moins une zone de scellement (25), qui est scellée par une masse de scellement (7), et au moins une zone sans masse de scellement (24) sont définies sur la carte de circuits imprimés (6).

8. Unité électronique (1) selon la revendication 7, **caractérisée en ce que** sont associées au masque de scellement (4) des géométries de référence (30), qui définissent l'orientation du masque de scellement (4) par rapport à la carte de circuits imprimés (6).

9. Unité électronique (1) selon la revendication 7 ou 8, **caractérisée en ce que** le masque de scellement (4) présente des éléments d'appui (31) pour soutenir le masque de scellement (4) sur la carte de circuits imprimés (6) et/ou sur le cadre de montage (2).

10. Unité électronique (1) selon la revendication 8 ou 9, **caractérisée en ce que** des ergots d'ancrage (32) sont réalisés sur les géométries de référence (30) et/ou sur les éléments d'appui (31).

11. Unité électronique (1) selon l'une quelconque des revendications 1 à 10, **caractérisée en ce que** le masque de scellement (4) présente un logement (36) pour loger un condensateur, dont l'ouverture de logement (37) est orientée de manière perpendiculaire par rapport à la direction d'insertion (10) de l'au moins un compartiment d'insertion (9).

12. Unité électronique (1) selon l'une quelconque des revendications 1 à 11, **caractérisée en ce que** le cadre de montage (2) présente une section transversale en forme de T, et que l'au moins une section de compartiment (8) est disposée au centre par rapport à l'espace de logement (3).

13. Unité électronique (1) selon l'une quelconque des revendications 1 à 12, **caractérisée en ce qu'**est prévu un dispositif de maintien de commutateur (15), avec un guide de commutateur (16), sur lequel un commutateur (33) peut être placé.

14. Unité électronique (1) selon l'une quelconque des revendications 1 à 13, **caractérisée en ce qu'**est réalisé sur le cadre de montage (2) un logement de commutateur (17) présentant un ajour, pour loger un commutateur rotatif (18) modifiant les caractéristiques d'entraînement de la machine-outil manuelle.

15. Unité électronique (1) selon l'une quelconque des revendications 1 à 14, **caractérisée en ce qu'**est réalisée sur le cadre de montage (2) du côté périphérique extérieur une section de couplage (29) qui est adaptée pour être couplée à des contre-sections de couplage correspondantes d'un carter de machine d'une machine-outil manuelle.

16. Unité électronique (1) selon l'une quelconque des revendications 1 à 15, **caractérisée en ce que** sont prévus sur la carte de circuits imprimés (7) des contacts de raccordement (40) autotaraudants pour raccorder des torons de raccordement non confectionnés d'un entraînement d'une machine-outil manuelle.
